# EUROPÄISCHE PATENTSCHRIFT

(11) **EP 2 289 077 B1**
(45) Veröffentlichungstag und Bekanntmachung des Hinweises auf die Patenterteilung: **02.11.2011**
(21) Anmeldenummer: 09769046.5
(22) Anmeldetag: 09.04.2009
(51) Int. Cl.: H01F 6/06

(54) **LEITERANORDNUNG FÜR EIN RESISTIVES SCHALTELEMENT MIT WENIGSTENS ZWEI LEITERVERBÜNDEN AUS SUPRALEITENDEN LEITERBÄNDERN**
CONDUCTOR ARRANGEMENT FOR A RESISTIVE SWITCHING ELEMENT HAVING AT LEAST TWO COMPOSITE CONDUCTORS MADE FROM SUPERCONDUCTING CONDUCTOR BANDS
AGENCEMENT CONDUCTEUR POUR UN ÉLÉMENT DE COMMUTATION RÉSISTIF AVEC AU MOINS DEUX FAISCEAUX CONDUCTEURS FAITS DE RUBANS SUPRACONDUCTEURS

(30) Priorität: 23.06.2008 DE 102008029722
(43) Veröffentlichungstag der Anmeldung: 02.03.2011
(73) Patentinhaber: Siemens Aktiengesellschaft, 80333 München (DE)
(72) Erfinder: KRÄMER, Hans-Peter, 91058 Erlangen (DE)
(86) Internationale Anmeldenummer: PCT/EP2009/054275
(87) Internationale Veröffentlichungsnummer: WO 2009/156197

(56) Entgegenhaltungen:
- EP-A- 0 503 447
- DE-A1- 4 234 312
- DE-B3-102006 032 702
- DE-B3-102006 032 972
- US-A- 3 205 413
- US-B1- 6 275 365

## Beschreibung

Die vorliegende Erfindung bezieht sich auf eine Leiteranordnung für ein resistives Schaltelement mit wenigstens einem ersten und wenigstens einem zweiten Leiterverbund. Die Leiterverbünde weisen jeweils zwei parallel verlaufende, einen bifilaren Aufbau bildende Leiterteile auf, die jeweils aus wenigstens einem supraleitenden Leiterband aufgebaut sind. Eine solche Leiteranordnung ist z.B. aus der US 6 275 365 B1 bekannt.

In Stromnetzen wird elektrische Energie vom Erzeuger zu den Verbrauchern transportiert. Dabei sind Kurzschlüsse zu vermeiden, da sie zu irreparablen Schäden an Anlagen führen können. Eine Möglichkeit, in Stromnetzen, Kurzschlüsse zu vermeiden ist die Verwendung von sogenannten Kurzschluss-Strombegrenzern.

Eine besonders günstige Form bezüglich der Schalteigenschaften und Kosten im Betrieb sind supraleitende Kurzschluss-Strombegrenzer. Diese weisen im Betrieb auf Grund der Supraleitung keine oder nur sehr geringe Verlustleistungen auf und zeichnen sich durch ihr schnelles, reversibles Schalten aus. Ihr Funktionsprinzip beruht auf dem Übergang einer Supraleitungsanordnung vom supraleitenden in den normalleitenden Zustand beim Auftreten eines Kurzschluss-Stromes. Die im Netz in Reihe geschaltete Supraleitungsanordnung schaltet durch diesen Übergang sehr schnell einen Widerstand in das Netz, welcher den Kurzschluss-Strom begrenzt. Dadurch wird das Netz und die damit verbundenen Anlagen gegenüber dem Kurzschluss-Strom geschützt. Nach Abklingen des Kurzschluss-Stromes ist der Kurzschluss-Strombegrenzer in der Lage, den zusätzlichen Widerstand wieder aus dem Netz zu entfernen, indem nach Abkühlung unter eine kritische Temperatur die Supraleitungsanordnung vom normalleitenden in den supraleitenden Zustand zurück kehrt. Eine nahezu verlustfreie Stromübertragung über den Strombegrenzer im Netz ist wieder möglich.

Aus dem Stand der Technik, z.B. aus US 6 275 365 B1, sind supraleitende Kurzschluss-Strombegrenzer mit bifilar nebeneinander gewickelten supraleitenden Spulen bekannt. Eine Spule ist jeweils aus einem Leiterband aufgebaut, welches aus zwei Leiterteilen besteht und um einen zylindrischen Spulenkern gewickelt ist. Das Leiterband ist über sich selbst gefaltet, wobei die zwei benachbarten Leiterteile entstehen, und jedes Leiterteil ist gegenüber einem benachbarten Leiterteil durch eine Isolatorschicht elektrisch getrennt. Benachbarte Spulen sind auf unterschiedlichen Positionen entlang der Achse des zylindrischen Spulenkerns gewickelt. Die benachbarten Spulen können parallel miteinander verschaltet werden. Dabei treten jedoch Probleme bezüglich der Spannungsfestigkeit der Spulen auf. Die gesamte an einer Spule anliegende Spannung fällt bei diesem Aufbau an den beiden äußeren Windungen ab. Bei Nennspannungen, insbesondere größer 10 kV, werden aufgrund der benötigten Abstände zwischen den Leiterteilen die Induktivitäten, die Verluste und der Platzbedarf sehr groß.

Aufgabe der Erfindung ist es, eine verbesserte Leiteranordnung für ein resistives Schaltelement, insbesondere einen Kurzschluss-Strombegrenzer mit den eingangs genannten Merkmalen anzugeben, mit einer hohen Spannungsfestigkeit bei kompaktem Aufbau, geringer Induktivität und geringen Wechselfeldverlusten, wobei eine gute Zugänglichkeit von Kühlmittel zu den verwendeten Leiterbändern gegeben ist.

Die angegebene Aufgabe wird für die Leiteranordnung eines resistiven Schaltelements mit den Merkmalen des Anspruchs 1 gelöst.

Die erfindungsgemäße Leiteranordnung für ein resistives Schaltelement umfasst wenigstens einen ersten und wenigstens einen zweiten Leiterverbund, welcher jeweils aus wenigstens einem supraleitenden Leiterband aufgebaut ist. In der Leiteranordnung weist jeder Leiterverbund zwei parallel verlaufende, einen bifilaren Aufbau bildende Leiterteile aus dem wenigstens einen Leiterband auf. Der wenigstens eine erste und der wenigstens eine zweite Leiterverbund sind in einer gemeinsamen Ebene benachbart zueinander verlaufend, gegenseitig isoliert zu einer gemeinsamen Spulenwicklung geformt, wobei deren Windungen weitgehend nach Art einer Spirale verlaufen.

Vorteilhafte Ausgestaltungen der erfindungsgemäßen Leiteranordnung gehen aus den jeweils zugeordneten abhängigen Unteransprüchen hervor.

In einer bevorzugten Ausführungsform der Leiteranordnung ist die Spirale in Form einer archimedischen oder einer logarithmischen oder einer hyperbolischen oder einer fermatischen Spirale ausgebildet. Dabei sind die zwei parallel verlaufenden, einen bifilaren Aufbau bildenden Leiterteile eines Leiterverbundes elektrisch und/oder mechanisch miteinander jeweils an ihren Enden und/oder Anfängen verbunden, wobei wenigstens eine Verbindungsstelle ausgebildet ist.

In einer besonders bevorzugten Ausführungsform ist wenigstens eine Verbindungsstelle in Form zweier spitz aufeinander zulaufender Anfänge und/oder Enden ausgebildet. Alternativ kann die wenigstens eine Verbindungsstelle in U-Form, insbesondere in zu einer Seite der U-Form verbogener Form ausgebildet sein, und/oder die Verbindung kann in doppelter U-Form, insbesondere in S-Form ausgebildet sein. Es ist auch möglich, dass wenigstens ein Leiterband an der wenigstens einen Verbindungsstelle eines Leiterverbundes eine teilweise elliptische, insbesondere teilweise kreisrunde Form aufweist. Auch Kombinationen der Formen der Verbindungsstellen sind möglich.

Eine bevorzugte Ausführungsform sieht vor, dass wenigstens zwei Verbindungsstellen in der gemeinsamen Ebene gestapelt angeordnet sind. Alternativ können wenigstens zwei Verbindungsstellen auch in der gemeinsamen Ebene auf einem Umfang einer Ellipse, insbesondere eines Kreises, angeordnet sein. Dabei ist besonders bevorzugt, dass die wenigstens zwei Verbindungsstellen auf dem Umfang gleichmäßig verteilt sind. Sie können bevorzugt im oder nahe dem Mittelpunkt einer Spirale angeordnet sein.

Das supraleitende Leiterband umfasst in einer bevorzugten Ausführungsform Hochtemperatur-Supraleiter-Material. Zwischen benachbarten Leiterteilen, insbesondere zwischen benachbarten Leiterteilen eines Leiterverbundes und zwischen benachbarten Leiterteilen benachbarter Leiterverbünde, ist eine Isolierung ausgebildet. Bevorzugt ist die Isolierung in Form wenigstens eines Abstandshalters ausgebildet, insbesondere eines Abstandshalters, welcher einen Abstand zwischen benachbarten Leiterteilen im Bereich von 2 bis 3 Millimetern ergibt.

Die zwei Leiterteile eines Leiterverbundes sind besonders bevorzugt so ausgebildet, dass sie Strom in entgegengesetzte Richtungen leiten. Benachbarte Leiterteile benachbarter Leiterverbünde können so ausgebildet sein, dass sie ebenfalls Strom in entgegengesetzte Richtungen leiten.

In einer besonders bevorzugten Ausführungsform der Leiteranordnung sind der wenigstens eine erste und der wenigstens eine zweite Leiterverbund parallel geschaltet. Alternativ können der wenigstens eine erste und der wenigstens eine zweite Leiterverbund auch in Reihe geschaltet sein. Auch Kombinationen von Verschaltungen unterschiedlicher Leiterverbünde sind möglich.

Die Verbindungsstellen der Leiterteile von Leiterverbünden sind bevorzugt elektrisch und/oder mechanisch miteinander verbunden. Unter Verbunden soll im Weiteren eine Verbindung elektrisch und/oder mechanisch zuvor getrennter Teile verstanden werden oder eine elektrische und/oder mechanische Verbindung, welche bei Leiterteilen besteht, die aus einem Stück gefertigt sind. Im ersteren Falle, einer Verbindung zuvor getrennter Teile, kann die Verbindung z.B. durch Löten oder Schweißen hergestellt sein.

Der Erfindung liegt allgemein die Idee zu Grunde, dass eine dem zu schützenden Netz in Reihe geschaltete Supraleiteranordnung beim Auftreten eines Kurzschlusses vom supraleitenden in den normal leitenden Zustand übergeht und dadurch sehr schnell einen Widerstand in das Netzt schaltet, welcher den Kurzschluss-Strom begrenzt. Im Begrenzungsfall fällt fast die gesamte Nennspannung in Stromrichtung im Wesentlichen linear entlang der Leiteranordnung ab. Dabei muss die Anordnung für das Leiterband bestimmte Kriterien optimal erfüllen, die vorteilhaft mit der erfindungsgemäßen Ausgestaltung der Leiteranordnung zu gewährleisten sind.

Zum einen sollte das Leiterband so angeordnet sein, dass eine möglichst niedrige Induktivität auftritt, damit der Strombegrenzer im Normalzustand für das Netz quasi 'unsichtbar' ist. Dies kann prinzipiell erreicht werden, indem man Leiterbereiche mit gegengerichteten Strömen in möglichst kleinen Abständen zueinander anordnet. Als Faustregel gilt, dass der Leiterabstand kleiner als die Leiterbreite sein sollte.

Ein weiteres Kriterium für die Anordnung des Leiterbandes ist, eine Anordnung zu wählen, bei welcher möglichst niedrige Wechselfeldverluste auch für Strombegrenzer mit Nennströmen von mehreren kA (Kilo Ampere) auftreten. Größere Wechselfeldverluste erhöhen die Gesamtverluste und damit die Betriebskosten und bedingen den Einsatz einer größeren und damit teureren Kältemaschine. Wechselfeldverluste entstehen, wenn sich magnetischer Fluss in den Supraleiter hinein- oder herausbewegt. Die Wechselfeldverluste können prinzipiell klein gehalten werden durch geeignete Parallelschaltung von Einzelleitern mit kleinerem Querschnitt oder durch eine Anordnung, bei welcher das entstehende Magnetfeld klein gehalten wird, wie z.B. bei gegengerichteten Strömen in möglichst kleinen Abständen. Um diesen Effekt zu erreichen, muss der Abstand deutlich kleiner als die Leiterbreite sein.

Die Anordnung des Leiterbandes sollte einen möglichst kompakten Aufbau aufweisen. Dies kann im Wesentlichen durch kleine Abstände zwischen den Leitern innerhalb eines Schaltelements sowie zwischen gegebenenfalls vorhandenen Schaltelementen erreicht werden.

Weiterhin sollte die Anordnung des Leiterbandes eine gute Zugänglichkeit für das Kühlmittel ermöglichen. Üblicherweise wird als Kühlmittel flüssiger Stickstoff verwendet. Eine gute Zugänglichkeit für das Kühlmittel zum Leiterband ermöglicht eine schnelle Rückkühlung nach einem Schaltvorgang. Dies kann dadurch erreicht werden, dass die Leiteroberfläche, abgesehen von einer eventuell vorhandenen dünnen Isolierschicht, im Wesentlichen freiliegend von dem Kühlmittel benetzt werden kann. Insbesondere soll die Leiteranordnung nicht vergossen sein, z.B. mit einem Epoxidharz. Um eine schnelle Rückkühlung nach einem Schaltvorgang zu gewährleisten, ist erfahrungsgemäß ein Mindest-Abstand von ca. 2 - 3 mm zwischen benachbarten Leiterbändern ausreichend.

Ein weiteres Kriterium für die Anordnung des Leiterbandes ist die Spannungsfestigkeit. Die in dielektrischen Prüfungen geforderte Spannungsfestigkeit liegt grob um den Faktor 5 - 10 über der im Begrenzungsfall anliegenden Spannung, welche ungefähr der Nennspannung des Netzes entspricht. Die Spannungsfestigkeit ist besonders wichtig für den Einsatz in der Hochspannungstechnik und wird üblicherweise durch größere Abstände, Beschichtung der Oberflächen mit Kunststoffen oder durch Vergießen mit Epoxidharz erreicht. Diese Anforderungen für Spannungsfestigkeit stehen damit im Widerspruch zu den zuvor genannten anderen Anforderungen. Eine Optimierung zwischen den Kriterien ist mit der in der Erfindung vorliegenden Ausführungsform eines resistiven Schaltelements, d.h. Strombegrenzers gegeben.

Insbesondere die Anordnung von wenigstens einem ersten und wenigstens einem zweiten Leiterverbund, jeweils aus supraleitenden Leiterband bifilar aufgebaut, parallel verlaufend in einer gemeinsamen Ebene in Art einer Spirale, ergibt eine optimale Ausführungsform nach den zuvor genannten Kriterien. Dabei ergibt die Isolierung in Form von wenigstens einem Abstandshalter eine gute Zugänglichkeit des Kühlmittels und eine optimale Beabstandung des Leiterbandes. Die Anordnung in einer Ebene ermöglicht einen besonders kompakten Aufbau. Eine Verschaltung der Leiterverbünde z.B. parallel ergibt einen entgegengesetzten Stromfluss in allen benachbarten Leiterbändern und so eine Minimierung der Verluste.

Durch das Parallelschalten mehrerer Leiterbänder wird die Länge der einzelnen Bänder selbst bei Spulen mit großen Durchmessern klein gehalten. Damit bleibt auch die Nennspannung pro Spule niedrig. Folglich besteht nicht die Notwendigkeit, den Abstand der Bänder aus Gründen der Spannungsfestigkeit über den für die Kriterien günstigen Abstand von 2-3 mm zu vergrößern. Durch die bifilare Anordnung mit kleinen Abständen werden die erzeugten Magnetfelder minimiert, was sowohl zu einer niedrigen Induktivität als auch zu geringen Wechselfeldverlusten führt. Bei Strombegrenzern für die Niederspannung ist diese Anordnung ebenfalls von Vorteil, weil durch die Parallelschaltung der Bänder größere Spulen verwendet und dadurch die Raumausnutzung deutlich verbessert werden können.

Durch die erfindungsgemäße Anordnungen der Leiterbänder werden Probleme bei der Spannungsfestigkeit, wie sie in bifilaren Scheibenspulen oder ineinander geschachtelten Solenoidspulen nach dem Stand der Technik entstehen, da zwischen den äußeren beiden Windungen praktisch die gesamte an der Spule anliegende Spannung abfällt, gelöst. Der kompakte Aufbau reduziert Verluste, welche auftreten bei Hochspannung an Anordnungen mit vielen kleinen in Reihe geschalteten oder bei großen Nennströmen auch parallel geschalteten Spulen nach dem Stand der Technik. Bei Aufbauformen mit allen Spulen axial in einer Reihe angeordnet, ergibt sich eine ungünstige langgestreckte Geometrie, und bei Spulen nebeneinander in parallelen Stapeln angeordnet, ergibt sich zwangsläufig eine schlechte Raumausnutzung im Kryostaten. Diese Probleme sind in der erfindungsgemäßen Anordnung überwunden.

Auch ein vergrößerter Spulendurchmesser führt zu einer schlechteren Raumausnutzung, einer größeren Induktivität sowie höheren Wechselfeldverlusten. Durch einen vergrößerten Spulendurchmesser wird die Leiterlänge pro Spule und die Nennspannung pro Spule vergrößert. Folglich muss, um die Spannungsfestigkeit zu gewährleisten, auch der Abstand zwischen den Bändern vergrößert werden. Für Anwendungen mit hohen Strömen ergeben sich Möglichkeiten, den kritischen Strom pro Band zu erhöhen durch Vergrößern der Leiterbreite oder durch eine Anordnung mehrerer Spulen mit schmalen Bändern parallel geschaltet. Eine Erhöhung des Leiterstromes vergrößert überproportional stark die Wechselfeldverluste, sofern nicht eine bifilare Anordnung mit sehr kleinem Abstand zwischen den Wicklungen verwendet werden kann. Das Parallelschalten vieler Spulen mit schmalen Bändern verschlechtert wiederum die Raumausnutzung. Die erfindungsgemäße Anordnung der Leiterbänder hingegen gibt die Möglichkeit, eine optimale Raumausnutzung bei minimierten Verlusten zu gewährleisten.

Bevorzugte Ausführungsformen der Erfindung mit vorteilhaften Weiterbildungen gemäß den Merkmalen der abhängigen Ansprüche werden nachfolgend anhand der Figuren der Zeichnung näher erläutert, ohne jedoch darauf beschränkt zu sein. Dabei sind den in den Figuren sich entsprechenden Teilen jeweils dieselben Bezugszeichen zugeordnet.

Es zeigen jeweils in schematischer Darstellung:
- Fig. 1: eine erfindungsgemäße Leiteranordnung für ein resistives Schaltelement mit drei Leiterverbünden,
- Fig. 2: eine Leiteranordnung analog der in Fig. 1, nur mit sechs statt drei Leiterverbünden,
- Fig. 3: eine Leiteranordnung analog der in Fig. 1, mit U-förmigen Verbindungsstellen,
- Fig. 4: eine Leiteranordnung analog der in Fig. 3, mit U- bzw. S-förmigen Verbindungsstellen,
- Fig. 5: eine Leiteranordnung analog der in Fig. 1, mit spitz geformten Verbindungsstellen und
- Fig. 6: eine Leiteranordnung analog der in Fig. 4, mit ineinander geschachtelten Verbindungsstellen.

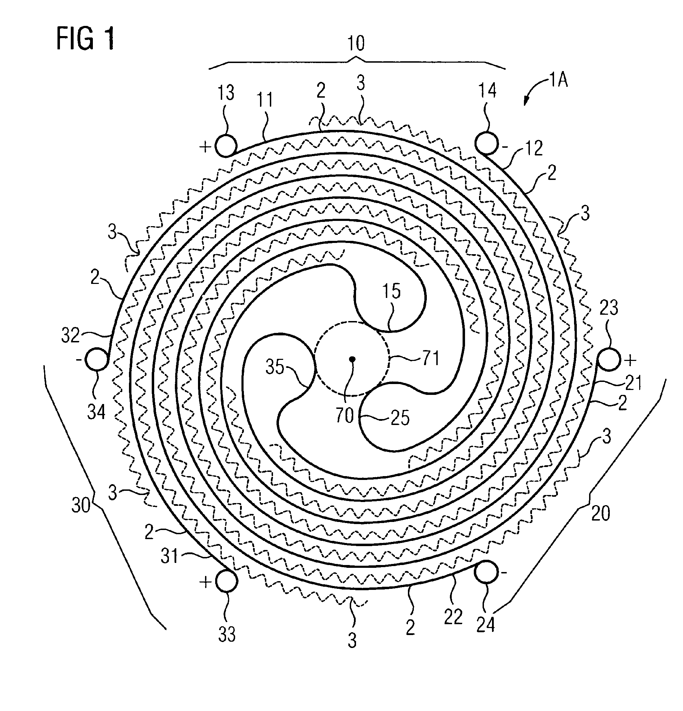

In Fig. 1 ist eine schematische Darstellung einer erfindungsgemäßen Leiteranordnung 1A für ein resistives Schaltelement gezeigt, welche drei Leiterverbünden, Leiterverbund 10, 20 und 30 umfasst. Jeder Leiterverbund 10, 20, 30 besteht aus wenigstens einem supraleitenden Leiterband 2. Jeder Leiterverbund 10, 20, 30 weist zwei parallel verlaufende, einen bifilaren Aufbau bildende Leiterteile 11, 12 bzw. 21, 22 bzw. 31, 32 auf, mit jeweils einer zentralen Verbindungsstelle 15, 25, 35. Die Leiterverbünde 10, 20, 30 sind in einer gemeinsamen Ebene benachbart zueinander angeordnet und gegenseitig isoliert. Die Leiterverbünde 10, 20, 30 sind zu einer gemeinsamen Spulenwicklung geformt, deren Windungen weitgehend nach Art einer Spirale verlaufen. Die Verbindungsstellen 15, 25, 35 der Leiterverbünde 10, 20, 30 sind jeweils teilweise kreisrund ausgebildet und in der Ebene einen Kreisradius 71 um den Mittelpunkt der Spirale 70 tangierend angeordnet.

Zwischen den zwei benachbarten Leiterteilen 11, 12 bzw.21, 22 bzw. 31, 32 eines Leiterverbundes 10, 20, 30 sind jeweils Abstandshalter 3 angeordnet, welche als elektrische Isolatoren zwischen den Leiterbändern 2 dienen. In der Fig. 1 sind die Abstandshalter 3 als gewellte Linien dargestellt. Ihr Aufbau kann unterschiedlich ausgebildet sein, insbesondere können sie die Leiterbänder 2 sowohl in einer Richtung senkrecht zur dargestellten Zeichenebene als auch in Richtung der Ebene, d.h. relativ zueinander fixieren. In der Regel sind die Abstandshalter 3 aus Kunstoffen wie Teflon oder aus anderen, bei niedrigen Temperaturen stabilen, elektrisch isolierenden Materialien aufgebaut. Die Abstandshalter 3 sind in ihrer Form so ausgebildet, dass sie eine gute Zugänglichkeit von Kühlmittel zu den Leiterbändern 2 ermöglichen. Als Kühlmittel dient dabei insbesondere flüssiger Stickstoff, aber auch andere Kühlmittel wie z.B. flüssiges Helium oder flüssiges Neon sind möglich.

Die Leiterbänder 2 können aus supraleitendem Material, wie z.B. dem Hochtemperatur-Supraleiter-Material Bi₂Sr₂Ca₂Cu₃O (BSCCO (2223)) in einer Silberhülle, oder wie z.B. aus dem Selten-Erden-Kupfer-Oxid YBCO, auf einem Stahlband aufgebracht, aufgebaut sein. Eine besonders bevorzugte Form eines Leiterbandes ist durch eine Ausbildung als sogenannter Roebelleiter gegeben. Auch Kombinationen unterschiedlicher supraleitender Materialien mit niedriger Sprungtemperatur (LTS-Materialien) wie NbTi oder Nb₃Sn und/oder Hochtemperatur-Supraleitender (HTS) Materialien in bzw. auf normal leitenden Materialien sind möglich.

Die Leiterbänder 2 eines bifilaren Leiterverbundes 10, 20, 30 können aus einem Teil oder aus mehreren zusammengesetzten Teilen bestehen. Im Fall, dass ein einteiliges Leiterband 2 verwendet wird, entsteht ein Leiterverbund 10, 20, 30 durch Übereinander-Falten eines Leiterbandes 2, wobei die Faltstelle als Verbindungsstelle 15, 25, 35 im Weiteren bezeichnet wird und die Leiterteile 11, 12 bzw. 21, 22 bzw. 31, 32 miteinander verbindet. Bei zusammengesetzten Leiterbändern 2 entsteht ein bifilarer Leiterverbund 10, 20, 30 durch Übereinander-Stapeln zweier Leiterbänder 2, wobei ein Ende mechanisch und elektrisch insbesondere formschlüssig zusammengefügt wird, und damit jeweils die Leiterteile 11, 12 bzw. 21, 22 bzw. 31, 32 miteinander mechanisch und elektrisch verbunden sind. In diesem Fall wird im Weiteren die Stelle, an welcher die Leiterbänder 2 zusammengefügt sind, als Verbindungsstelle 15, 25, 35 bezeichnet. Ein Zusammenfügen kann im letzteren Fall z.B. durch Löten erfolgen.

Am den Verbindungsstellen 15, 25, 35 entgegengesetzten Ende des wenigstens einen Leiterbandes 2, d.h. in Fig. 1 am äußeren Rand der Spirale, sind an den Leiterteilen 11, 12, 21, 22, 31, 32 jeweils Anschlüsse 13, 14, 23, 24, 33, 34 zum elektrischen Kontaktieren angebracht. Über die Anschlüsse 13, 14, 23, 24, 33, 34 können die Leiterteile 11, 12, 21, 22, 31, 32 elektrisch kontaktiert werden, insbesondere in Reihe oder parallel untereinander verschaltet werden, und mit einer äußeren positiven bzw. negativen Spannung beaufschlagt werden.

Im in Fig. 1 dargestelltem Ausführungsbeispiel sind die Anschlüsse 13, 14, 23, 24, 33, 34 auf einem äußeren Umfangsradius der Spirale gleichmäßig angeordnet. Ein Leiterteil eines Leiterverbundes ist jeweils mit einem positiven Potential in Kontakt gebracht, und dass andere Leiterteil eines Leiterverbundes ist jeweils mit einem negativen Potential in Kontakt gebracht (positives Potential + bzw. negatives Potential -), wobei die Anschlüsse 13, 14 bzw. 23, 24 bzw. 33, 34 eines bifilaren Leiterverbundes 10 bzw. 20 bzw. 30 jeweils zueinander benachbart auf dem Umfangsradius angeordnet sind. Die Leiterverbünde sind so angeordnet und elektrisch kontaktiert, dass direkt benachbarte Leiterteile direkt benachbarter Leiterverbünde jeweils entgegengesetzte Vorzeichen der angelegten Potentiale aufweisen.

Die drei Verbindungsstellen 15, 25 und 35 des Leiterbandes 2 der drei Leiterverbünde 10, 20, 30 in Fig. 1 sind jeweils teilweise in kreisrunder Form ausgebildet. Sie sind im Inneren der Spirale, an einem Kreis 71 um den Mittelpunkt 70 der Spirale angeordnet. An dem Kreis 71 bedeutet in diesem Fall, dass sich jeweils die kreisrunde Form der Verbindungsstelle 15, 25, 35 mit dem Kreis 71 um den Mittelpunkt 70 in insbesondere genau einem Punkt schneidet.

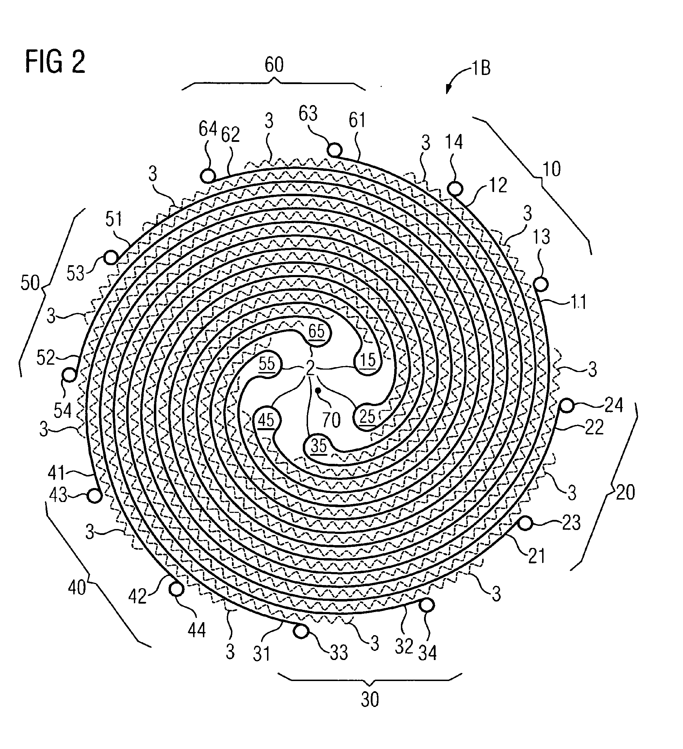

In Fig. 2 ist eine schematische Darstellung einer alternativen Ausführungsform der erfindungsgemäßen Leiteranordnung 1B dargestellt. Im Unterschied zur Leiteranordnung 1A in Fig. 1 weist die Leiteranordnung 1B in Fig. 2 sechs statt drei Leiterverbünde auf. Die Form und Anordnung der Leiterverbünde 10, 20, 30, 40, 50, 60 mit ihren jeweiligen Leiterteilen 11, 12 bzw. 21, 22 bzw. 31, 32 bzw. 41, 42 bzw. 51, 52 bzw. 61, 62 und Verbindungsstellen 15, 25, 35, 45, 55, 65 in Fig. 2 ist analog der Form und Anordnung der Leiterverbünde 10, 20, 30 mit ihren jeweiligen Leiterteilen 11, 12 bzw. 21, 22 bzw. 31, 32 und Verbindungsstellen 15, 25, 35 in Fig. 1, mit Ausnahme der räumlichen Dimensionen auf Grund der höheren Anzahl der Leiterverbünde.

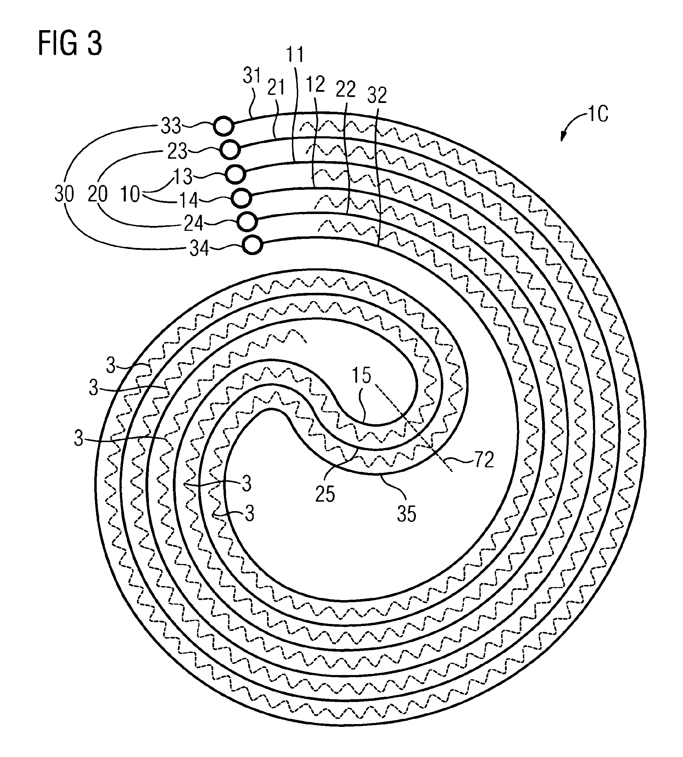

In Fig. 3 ist eine schematische Darstellung einer weiteren alternativen Ausführungsform der erfindungsgemäßen Leiteranordnung 1C dargestellt. Im Unterschied zu der in Fig. 1 gezeigten Leiteranordnung 1A weist die Leiteranordnung 1C in Fig. 3 ineinander gestapelte Leiterverbünde 10, 20, 30 mit auf einer Geraden 72 angeordneten, gestapelten Verbindungsstellen 15, 25, 35 auf. Abstandshalter 3 sind zwischen den Leiterbändern 2 angeordnet. Die Verbindungsstellen 15, 25, 35 sind jeweils in Form eines U ausgebildet, wobei die U-Form durch das Aufwickeln der Windungen zu einer Spirale zu einer Seite hin verbogen ist. Ein weiterer Unterschied der in Fig. 3 dargestellten erfindungsgemäßen Ausführungsform zu der Ausführungsform der erfindungsgemäßen Leiteranordnung 1A in Fig. 1, ist in der Anordnung der Anschlüsse 13, 14, 23, 24, 33, 34 gegeben. Die Anschlüsse in Fig. 3 sind nicht wie in Fig. 1 gleichmäßig auf dem Umfang der Spirale angeordnet, sondern übereinander an einer Stelle des Umfangs der Spirale in der Zeichenebene gestapelt. Die in Fig. 1 dargestellte Ausführungsform hat den Vorteil einer besseren Spannungsfestigkeit gegenüber der in Fig. 3 dargestellten Ausführungsform, da die Anschlüsse einen größeren räumlichen Abstand voneinander aufweisen. In bestimmten Fällen kann aus kontakttechnischen Gründen aber die in Fig. 3 gezeigte Anordnung von Vorteil sein.

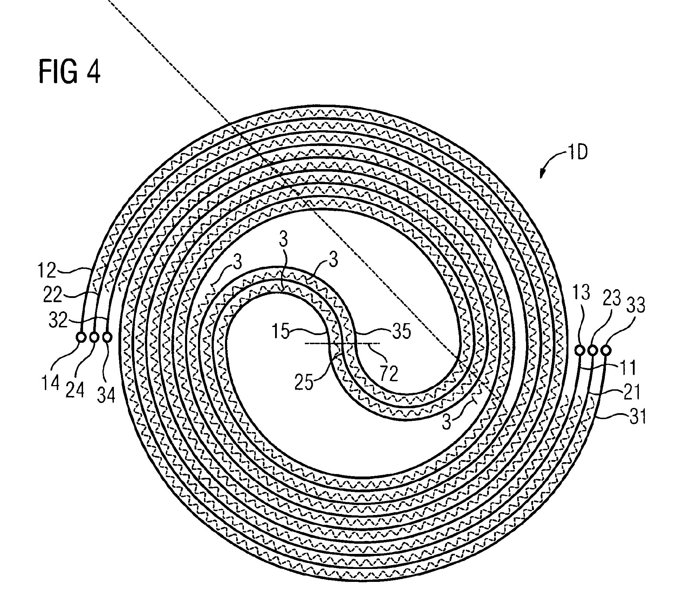

In Fig. 4 ist eine schematische Darstellung einer weiteren alternativen Ausführungsform der erfindungsgemäßen Leiteranordnung 1D dargestellt. Analog zu der in Fig. 3 gezeigten Leiteranordnung 1C weist die Leiteranordnung 1D in Fig. 4 ineinander gestapelte Leiterverbünde 10, 20, 30 mit auf einer Geraden 72 angeordneten, gestapelten Verbindungsstellen 15, 25, 35 auf, welche U-förmig bzw. S-förmig ausgebildet sind. Abstandshalter 3 sind zwischen den Leiterbändern 2 angeordnet. Im Unterschied zu der in Fig. 3 gezeigten Ausführungsform sind die Anschlüsse 12, 22, 32 der Leiterverbünde 10, 20, 30 jeweils vom ersten Leiterteil 11, 21, 31 auf einer Umfangsseite der Spirale entlang einer Geraden durch den Mittelpunkt der Spirale in der Zeichenebene übereinander gestapelt angeordnet, während die Anschlüsse 13, 23, 33 jeweils vom zweiten Leiterteil 14, 24, 34 der Leiterverbünde 10, 20, 30 auf der gegenüberliegenden Umfangsseite der Spirale auf der gleichen Geraden übereinander gestapelt angeordnet sind. Die angegebene erfinderische Ausführungsform der Fig. 4 gibt eine sehr gute Spannungsfestigkeit an.

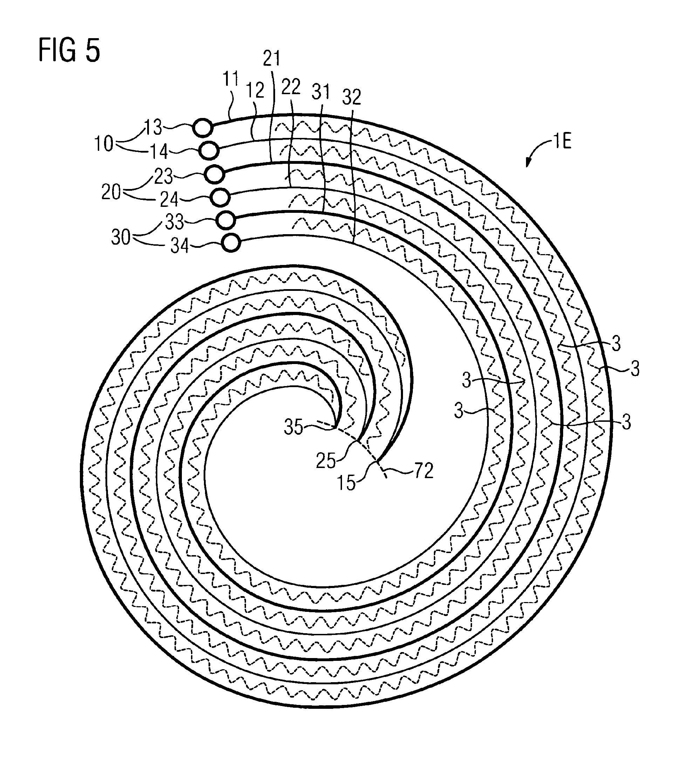

In Fig. 5 ist eine schematische Darstellung einer weiteren alternativen Ausführungsform der erfindungsgemäßen Leiteranordnung 1E dargestellt, mit spitz zulaufenden Verbindungsstellen 15, 25, 35. Analog zu der in Fig. 1 gezeigten Leiteranordnung 1A sind in der Leiteranordnung 1E der Fig. 5 keine ineinander, sondern nebeneinander gestapelte Verbindungsstellen 15, 25, 35 der Leiterverbünde 10, 20, 30 ausgeführt. Die Stapelfolge der Leiterteile des in Fig. 5 gezeigten Ausführungsbeispiels lautet von Außen nach Innen der Spirale betrachtet 11, 12, 21, 22, 31, 32, womit die Leiterteile eines Leiterverbundes jeweils immer benachbart zueinander angeordnet sind. Im Gegensatz dazu lautet die Stapelfolge der Leiterteile von Außen nach Innen der Spirale in den in den Fig. 3 und 4 gezeigten Ausführungsformen 31, 21, 11, 12, 22, 32. Somit sind im letzteren Fall die Leiterverbünde ineinander gestapelt, d.h. ineinander verschachtelt, und bis auf den innersten und äußersten Leiterverbund 10 und 30 sind Leiterteile immer ausschließlich mit Leiterteilen eines anderen Leiterverbundes direkt benachbart. In Fig. 5 sind die Verbindungsstellen 15, 25, 35 im Inneren der Spirale entlang der Zeichenebene übereinander entlang einer gebogenen Linie 72 gestapelt.

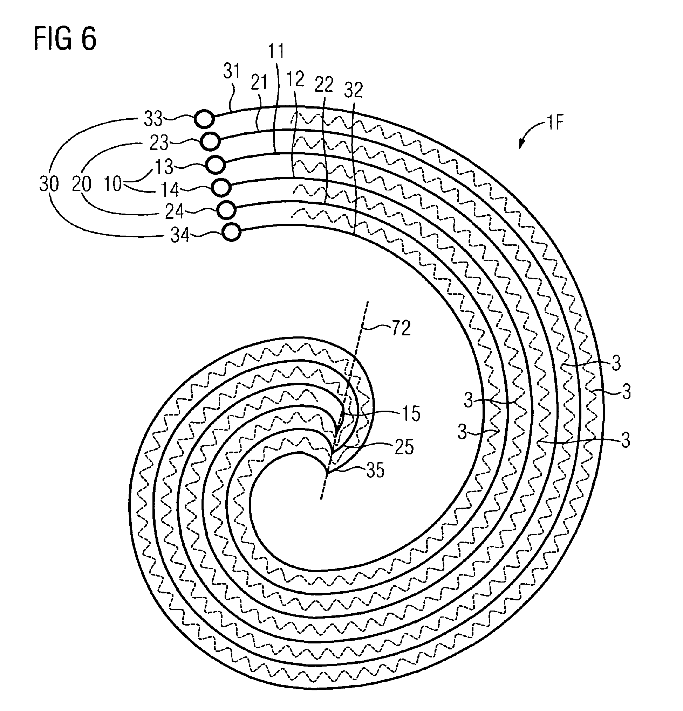

Ein weiteres Ausführungsbeispiel der erfinderischen Leiteranordnung 1F ist in Fig. 6 dargestellt, in welcher spitz ausgebildete Verbindungsstellen ineinander geschachtelt angeordnet sind. Somit entspricht die in Fig. 6 dargestellte Ausführungsform der in Fig. 3 dargestellten Ausführungsform 1C, mit Ausnahme der Form der Verbindungsstellen 15, 25, 35.

Eine Kombination einzelner Merkmale der in den Fig. 1 bis 6 gezeigten erfinderischen Ausführungsformen 1A bis 1F ist möglich. Insbesondere die Anordnung der Anschlüsse kann unabhängig von der Anordnung der Verbindungsstellen gewählt werden.

## Patentansprüche

1. Leiteranordnung (1A-1F) für ein resistives Schaltelement, in der die Leiteranordnung wenigstens einen ersten und wenigstens einen zweiten Leiterverbund (10, 20, 30, 40, 50, 60) aufweist, jeweils aus wenigstens einem supraleitenden Leiterband (2), in welcher Leiteranordnung (1A-1F) jeder Leiterverbund (10, 20, 30, 40, 50, 60) zwei parallel verlaufende, einen bifilaren Aufbau bildende Leiterteile (11, 12, 21, 22, 31, 32, 41, 42, 51, 52, 61, 62) aus dem wenigstens einen Leiterband (2) aufweist und der wenigstens eine erste und der wenigstens eine zweite Leiterverbund (10, 20, 30, 40, 50, 60) in einer gemeinsamen Ebene benachbart zueinander verlaufend, gegenseitig isoliert zu einer gemeinsamen Spulenwicklung geformt sind, deren Windungen weitgehend nach Art einer Spirale verlaufen, wobei zwischen benachbarten Leiterteilen eine Isolierung in Form wenigstens eines Abstandshalters ausgebildet ist.

2. Leiteranordnung (1A-1F) nach Anspruch 1, **dadurch gekennzeichnet, dass** die Art einer Spirale eine archimedrische, oder eine Logarithmische, oder eine Hyperbolische, oder eine fermatische Spirale umfasst.

3. Leiteranordnung (1A-1F) nach Anspruch 1 oder 2, **dadurch gekennzeichnet, dass** die zwei parallel verlaufenden, einen bifilaren Aufbau bildenden Leiterteile (11, 12, 21, 22, 31, 32, 41, 42, 51, 52, 61, 62) eines Leiterverbundes (10, 20, 30, 40, 50, 60) elektrisch und/oder mechanisch miteinander jeweils an ihren Enden und/oder Anfängen verbunden sind, wobei wenigstens eine Verbindungsstelle (15, 25, 35, 45, 55, 65) ausgebildet ist.

4. Leiteranordnung (1E, 1F) nach Anspruch 3, **dadurch gekennzeichnet, dass** wenigstens eine Verbindungsstelle (15, 25, 35, 45, 55, 65) eines Leiterverbundes (10, 20, 30, 40, 50, 60) in Form zweier spitz aufeinander zulaufender Anfänge und/oder Enden der Leiterteile (11, 12, 21, 22, 31, 32, 41, 42, 51, 52, 61, 62) ausgebildet ist.

5. Leiteranordnung (1A-1D) nach Anspruch 3, **dadurch gekennzeichnet, dass** wenigstens eine Verbindungsstelle (15, 25, 35, 45, 55, 65) eines Leiterverbundes (10, 20, 30, 40, 50, 60) in U-Form, insbesondere zu einer Seite der U-Form verbogener Form, ausgebildet ist und/oder dass die Verbindungsstelle (15, 25, 35, 45, 55, 65) in doppelter U-Form, insbesondere in S-Form ausgebildet ist.

6. Leiteranordnung (1A-1D) nach Anspruch 3, **dadurch gekennzeichnet, dass** das wenigstens eine Leiterband (2) an der wenigstens einen Verbindungsstelle (15, 25, 35, 45, 55, 65) eines Leiterverbundes (10, 20, 30, 40, 50, 60) eine teilweise elliptisch, insbesondere teilweise kreisrunde Form aufweist.

7. Leiteranordnung (1A-1F) nach einem der Ansprüche 3 bis 6, **dadurch gekennzeichnet, dass** wenigstens zwei Verbindungsstellen (15, 25, 35, 45, 55, 65) in der gemeinsamen Ebene gestapelt angeordnet sind.

8. Leiteranordnung (1A, 1B) nach einem der Ansprüche 3 bis 6, **dadurch gekennzeichnet, dass** wenigstens zwei Verbindungsstellen (15, 25, 35, 45, 55, 65) in der gemeinsamen Ebene auf einem Umfang einer Ellipse, insbesondere eines Kreises, angeordnet sind.

9. Leiteranordnung (1A, 1B) nach Anspruch 8, **dadurch gekennzeichnet, dass** die wenigstens zwei Verbindungsstellen (15, 25, 35, 45, 55, 65) auf dem Umfang gleichmäßig verteilt sind.

10. Leiteranordnung (1A-1F) nach einem der vorhergehenden Ansprüche, **dadurch gekennzeichnet, dass** die wenigstens zwei Verbindungsstellen (15, 25, 35, 45, 55, 65) im oder nahe dem Mittelpunkt einer Spirale angeordnet sind.

11. Leiteranordnung (1A-1F) nach einem der vorhergehenden Ansprüche, **dadurch gekennzeichnet, dass** das supraleitende Leiterband (2) Hochtemperatur-Supraleiter-Material umfasst.

12. Leiteranordnung (1A-1F) nach einem der vorhergehenden Ansprüche, **dadurch gekennzeichnet, dass** zwischen benachbarten Leiterteilen (11, 12, 21, 22, 31, 32, 41, 42, 51, 52, 61, 62) eines Leiterverbundes (10, 20, 30, 40, 50, 60) und zwischen benachbarten Leiterteilen (11, 12, 21, 22, 31, 32, 41, 42, 51, 52, 61, 62) benachbarter Leiterverbünde (10, 20, 30, 40, 50, 60), die Isolierung in Form wenigstens eines Abstandshalters (3) ausgebildet ist, insbesondere eines Abstandshalters (3), welcher einen Abstand zwischen benachbarten Leiterteilen (11, 12, 21, 22, 31, 32, 41, 42, 51, 52, 61, 62) im Bereich von 2 bis 3 Millimetern ausbildet.

13. Leiteranordnung (1A-1F) nach einem der vorhergehenden Ansprüche, **dadurch gekennzeichnet, dass** die zwei Leiterteile (11, 12, 21, 22, 31, 32, 41, 42, 51, 52, 61, 62) eines Leiterverbundes (10, 20, 30, 40, 50, 60) ausgebildet sind, Strom in entgegengesetzte Richtungen zu leiten, und dass benachbarte Leiterteile (11, 12, 21, 22, 31, 32, 41, 42, 51, 52, 61, 62) benachbarter Leiterverbünde (10, 20, 30, 40, 50, 60) ausgebildet sind, Strom in entgegengesetzte Richtungen zu leiten.

14. Leiteranordnung (1A-1F) nach einem der vorhergehenden Ansprüche, **dadurch gekennzeichnet, dass** der wenigstens ein erster und der wenigstens ein zweiter Leiterverbund (10, 20, 30, 40, 50, 60) in Reihe geschaltet sind.

15. Leiteranordnung (1A-1F) nach einem der Ansprüche 1 bis 13, **dadurch gekennzeichnet, dass** der wenigstens ein erster und der wenigstens ein zweiter Leiterverbund (10, 20, 30, 40, 50, 60) parallel geschaltet sind.

16. Leiteranordnung (1A-1F) nach einem der vorhergehenden Ansprüche, **dadurch gekennzeichnet, dass** die Verbindungsstellen (15, 25, 35, 45, 55, 65) der Leiterteile (11, 12, 21, 22, 31, 32, 41, 42, 51, 52, 61, 62) des wenigstens einen ersten und des wenigstens einen zweiten Leiterverbundes (10, 20, 30, 40, 50, 60) elektrisch und/oder mechanisch miteinander verbunden sind.

## Claims

1. Conductor arrangement (1A-1F) for a resistive switching element in which the conductor arrangement has at least one first and at least one second conductor assembly (10, 20, 30, 40, 50, 60), each comprising at least one superconducting conductor ribbon (2), in which conductor arrangement (1A-1F) each conductor assembly (10, 20, 30, 40, 50, 60) has two conductor parts (11, 12, 21, 22, 31, 32, 41, 42, 51, 52, 61, 62), which run parallel, form a bifilar structure and comprise at least one conductor ribbon (2), and the at least one first and the at least one second conductor assembly (10, 20, 30, 40, 50, 60) are formed such that they run adjacent to one another on a common plane and are insulated from one another to form a common coil winding, whose turns run largely in the form of a spiral, wherein insulation in the form of at least one spacer is formed between adjacent conductor parts.

2. Conductor arrangement (1A-1F) according to Claim 1, **characterized in that** the type of spiral comprises an Archimedes, a logarithmic, a hyperbolic or a fermatic spiral.

3. Conductor arrangement (1A-1F) according to Claim 1 or 2, **characterized in that** the two conductor parts (11, 12, 21, 22, 31, 32, 41, 42, 51, 52, 61, 62) which run parallel and form a bifilar structure in a conductor assembly (10, 20, 30, 40, 50, 60) are each electrically and/or mechanically connected to one another at their ends and/or starts, wherein at least one connection point (15, 25, 35, 45, 55, 65) is formed.

4. Conductor arrangement (1E, 1F) according to Claim 3, **characterized in that** at least one connection point (15, 25, 35, 45, 55, 65) of a conductor assembly (10, 20, 30, 40, 50, 60) is in the form of two starts and/or ends, which run to one another at a point, of the conductor parts (11, 12, 21, 22, 31, 32, 41, 42, 51, 52, 61, 62).

5. Conductor arrangement (1A-1D) according to Claim 3, **characterized in that** at least one connection point (15, 25, 35, 45, 55, 65) of a conductor assembly (10, 20, 30, 40, 50, 60) is formed in a U-shape, in particular in a shape which is bent to one side of the U-shape, and/or **in that** the connection point (15, 25, 35, 45, 55, 65) is in the form of a double U-shape, in particular an S-shape.

6. Conductor arrangement (1A-1D) according to Claim 3, **characterized in that** the at least one conductor ribbon (2) has a partially elliptical, in particular partially circular, shape at the at least one connection point (15, 25, 35, 45, 55, 65) of a conductor assembly (10, 20, 30, 40, 50, 60).

7. Conductor arrangement (1A-1F) according to one of Claims 3 to 6, **characterized in that** at least two connection points (15, 25, 35, 45, 55, 65) are arranged in a stack on the common plane.

8. Conductor arrangement (1A, 1B) according to one of Claims 3 to 6, **characterized in that** at least two connection points (15, 25, 35, 45, 55, 65) are arranged on a circumference of an ellipse, in particular of a circle, on the common plane.

9. Conductor arrangement (1A, 1B) according to Claim 8, **characterized in that** the at least two connection points (15, 25, 35, 45, 55, 65) are distributed uniformly on the circumference.

10. Conductor arrangement (1A-1F) according to one of the preceding claims, **characterized in that** the at least two connection points (15, 25, 35, 45, 55, 65) are arranged at or close to the center point of a spiral.

11. Conductor arrangement (1A-1F) according to one of the preceding claims, **characterized in that** the superconducting conductor ribbon (2) is composed of high-temperature superconductor material.

12. Conductor arrangement (1A-1F) according to one of the preceding claims, **characterized in that** the insulation in the form of at least one spacer (3) is formed between adjacent conductor parts (11, 12, 21, 22, 31, 32, 41, 42, 51, 52, 61, 62) of a conductor assembly (10, 20, 30, 40, 50, 60), and between adjacent conductor parts (11, 12, 21, 22, 31, 32, 41, 42, 51, 52, 61, 62) of adjacent conductor assemblies (10, 20, 30, 40, 50, 60), in particular a spacer (3) which separates adjacent conductor parts (11, 12, 21, 22, 31, 32, 41, 42, 51, 52, 61, 62) by a spacing in the range from 2 to 3 mm.

13. Conductor arrangement (1A-1F) according to one of the preceding claims, **characterized in that** the two conductor parts (11, 12, 21, 22, 31, 32, 41, 42, 51, 52, 61, 62) of a conductor assembly (10, 20, 30, 40, 50, 60) are designed to carry current in opposite directions, and **in that** adjacent conductor parts (11, 12, 21, 22, 31, 32, 41, 42, 51, 52, 61, 62) of adjacent conductor assemblies (10, 20, 30, 40, 50, 60) are designed to carry currents in opposite directions.

14. Conductor arrangement (1A-1F) according to one of the preceding claims, **characterized in that** the at least one first and the at least one second conductor assembly (10, 20, 30, 40, 50, 60) are connected in series.

15. Conductor arrangement (1A-1F) according to one of Claims 1 to 13, **characterized in that** the at least one first and the at least one second conductor assembly (10, 20, 30, 40, 50, 60) are connected in parallel.

16. Conductor arrangement (1A-1F) according to one of the preceding claims, **characterized in that** the connection points (15, 25, 35, 45, 55, 65) of the conductor parts (11, 12, 21, 22, 31, 32, 41, 42, 51, 52, 61, 62) of the at least one first and of the at least one second conductor assembly (10, 20, 30, 40, 50, 60) are electrically and/or mechanically connected to one another.

## Revendications

1. Agencement ( 1A à 1F ) conducteur pour un élément de commutation résistif, dans lequel l'agencement conducteur a au moins un premier et au moins un deuxième conducteur ( 10, 20, 30, 40, 50, 60 ) composite, composé respectivement d'au moins un ruban ( 2 ) supraconducteur, agencement ( A1 à 1F ) conducteur dans lequel chaque conducteur ( 10, 20, 30, 40, 50, 60 ) composite a deux parties ( 11, 12, 21, 22, 31, 32, 41, 42, 51, 52, 61, 62 ) en le au moins un ruban ( 2 ) conducteur, s'étendant parallèlement et formant une structure bifilaire et le au moins un premier et le au moins un deuxième conducteurs ( 10, 20, 30, 40, 50, 60 ) composite sont, en étant isolés mutuellement et en s'étendant en étant voisins l'un de l'autre dans un plan commun, conformés en enroulement de bobine commun dont les spires s'étendent dans une grande mesure à la manière d'une spirale, un isolant sous la forme d'au moins un intercalaire étant formé entre deux parties de conducteur voisines.

2. Agencement ( 1A à 1F ) suivant la revendication 1, **caractérisé en ce que** la spirale est d'un type d'une spirale d'Archimède ou d'une spirale logarithmique ou d'une spirale hyperbolique ou d'une spirale de Fermat.

3. Agencement ( 1A à 1F ) suivant la revendication 1 ou 2, **caractérisé en ce que** les deux parties ( 11, 12, 21, 22, 31,32, 41, 42, 51, 52, 61, 62 ) de conducteur, s'étendant parallèlement et formant une structure bipolaire, d'un conducteur ( 10, 20, 30, 40, 50, 60 ) composite sont reliées électriquement et/ou mécaniquement entre elles respectivement à leur fin et/ou à leur début, au moins un point ( 15, 25, 35, 45, 55, 65 ) de liaison étant formé.

4. Agencement ( 1E, 1F ) suivant la revendication 3, **caractérisé en ce qu'**au moins un point ( 15, 25, 35, 45, 55, 65 ) de liaison d'un conducteur ( 10, 20, 30, 40, 50, 60 ) composite est sous la forme de deux débuts et/ou fins des parties ( 11, 12, 21, 22, 31, 32, 41, 42, 51, 52, 61, 62 ) de conducteur allant l'une sur l'autre en pointe.

5. Agencement ( 1A à 1D ) suivant la revendication 3, **caractérisé en ce qu'**au moins un point ( 15, 25, 35, 45, 55, 65 ) de liaison d'un conducteur ( 10, 20, 30, 40, 50, 60 ) composite est en forme de U, notamment sous une forme courbée d' un côté de la forme en U et/ou **en ce que** le point ( 15, 25, 35, 45, 55, 65 ) de liaison est en forme de U double, notamment en forme de S.

6. Agencement ( 1A à 1D ) suivant la revendication 3, **caractérisé en ce que** le au moins un ruban ( 2 ) conducteur a, sur le au moins un point ( 15, 25, 35, 45, 55, 65 ) de liaison d'un conducteur ( 10, 20, 30, 40, 50, 60 ) composite, une forme en partie elliptique, notamment en partie circulaire.

7. Agencement ( 1A à 1F ) suivant l'une des revendications 3 à 6, **caractérisé en ce qu'**au moins deux points ( 15, 25, 35, 45, 55, 65 ) de liaison sont disposés de manière empilés dans le même plan.

8. Agencement ( 1A, 1B ) suivant l'une des revendications 3 à 6, **caractérisé en ce qu'**au moins deux points ( 15, 25, 35, 45, 55, 65 ) de liaison sont disposés dans le plan commun sur un pourtour d'une ellipse, notamment d'un cercle.

9. Agencement ( 1A, 1B ) suivant la revendication 8, **caractérisé en ce que** les au moins deux points ( 15, 25, 35, 45, 55, 65 ) de liaison sont répartis uniformément sur le pourtour.

10. Agencement ( 1A à 1F ) suivant l'une des revendications précédentes, **caractérisé en ce que** les au moins deux points ( 15, 25, 35, 45, 55, 65 ) de liaison sont disposés au centre ou près du centre d'une spirale.

11. Agencement ( 1A à 1F ) suivant l'une des revendications précédentes, **caractérisé en ce que** le ruban ( 2 ) conducteur supraconducteur comprend du matériau supraconducteur à haute température.

12. Agencement ( 1A à 1F ) suivant l'une des revendications précédentes, **caractérisé en ce que** l'isolant est formé, entre deux parties ( 11, 12, 21, 22, 31, 32, 41, 42, 51, 52, 61, 62 ) de conducteur voisines d'un conducteur ( 10, 20, 30, 40, 50, 60 ) composite et entre deux parties ( 11, 12, 21, 22, 31, 32, 41, 42, 51, 52, 61, 62 ) de conducteur voisines de conducteurs ( 10, 20, 30, 40, 50, 60 ) composites voisins, sous la forme d'au moins un intercalaire ( 3 ), notamment d'un intercalaire ( 3 ) qui forme une distance entre les parties ( 11, 12, 21, 22, 31, 32, 41, 42, 51, 52, 61, 62 ) de conducteur voisines de l'ordre de 2 à 3 mm.

13. Agencement ( 1A à 1F ) suivant l'une des revendications précédentes, **caractérisé en ce que** les deux parties ( 11, 12, 21, 22, 31, 32, 41, 42, 51, 52, 61, 62 ) de conducteur d'un conducteur ( 10, 20, 30, 40, 50, 60 ) composite sont constitués pour conduire du courant dans des sens opposés et ce que des parties ( 11, 12, 21, 22, 31, 32, 41, 42, 51, 52, 61, 62 ) de conducteur voisines de conducteurs ( 10, 20, 30, 40, 50, 60 ) composite voisins sont constituées pour conduire du courant dans des sens opposés.

14. Agencement ( 1A à 1F ) suivant l'une des revendications précédentes, **caractérisé en ce que** le au moins un premier et le au moins un deuxième conducteurs ( 10, 20, 30, 40, 50, 60 ) composite sont montés en série.

15. Agencement ( 1A à 1F ) suivant l'une des revendications 1 à 13, **caractérisé en ce que** le au moins un premier et le au moins un deuxième conducteurs ( 10, 20, 30, 40, 50, 60 ) composite sont montés en parallèle.

16. Agencement ( 1A à 1F ) suivant l'une des revendications précédentes, **caractérisé en ce que** les points ( 15, 25, 35, 45, 55, 65 ) de liaison des parties ( 11, 12, 21, 22, 31, 32, 41, 42, 51, 52, 61, 62 ) de conducteur du au moins un premier et du au moins un deuxième conducteurs ( 10, 20, 30, 40, 50, 60 ) composites sont reliés électriquement et/ou mécaniquement entre eux.
